# EUROPEAN PATENT APPLICATION

(11) **EP 4 686 002 A1**
(43) Date of publication of application: **28.01.2026**
(21) Application number: 24189936.8
(22) Date of filing: 22.07.2024
(51) Int. Cl.: H01R 4/01

(54) **METHOD FOR CONNECTING AN ELECTRIC CONDUCTOR TO A PCB**

(71) Applicant: HELLA GmbH & Co. KGaA, 59552 Lippstadt (DE)
(72) Inventor: Quentin, Abily, 31300 Toulouse (FR); GALAUP, Helene, 31300 Toulouse (FR); Ortin, Enzo, 31300 Toulouse (FR)
(74) Representative: Behr-Wenning, Gregor

(57) **Abstract**

The present invention relates to a method for connecting an electric conductor (1) to a PCB (2), comprising providing an electric connector (3), widening a coupling side (5) of the electric connector (3), which comprises an SMA material, from a memorized initial shape (M) to a widened coupling shape (W). Inserting the electric conductor (1) into the electric connector (3) at the coupling side (5) and thermally activating the electric connector (3) at the coupling side (5) in a way that the coupling side (5) is reshaping in the direction of the memorized initial shape (M) and the electric conductor (1) is clamped by the coupling side (5). The invention also relates to an electric device (7).

## Description

The present invention relates to a method for connecting an electric conductor to a PCB. The invention also relates to an electric device with a generic connection.

There are many different methods known for connecting an electric component, such as a semiconductor, an electric motor, a switch or the like, to a PCB. The term PCB stands for the expression "*printed circuit board*" and is also denoted as printed circuit plate, conductor board, conductor plate, card or etched wiring board. For establishing the connection to the PCB, the electric component comprises an electric conductor, such as a wire, a pin, a busbar or the like.

Common methods for connecting the electric conductor to the PCB are soldering, welding, pressing or screwing. For soldering or welding, it is known to insert an end of the electric conductor from a frond side of the PCB into a through hole of the PCB and perform the soldering or welding on the PCB with the end of the electric conductor, which is protruding from the backside of the PCB. For pressing or screwing, the PCB comprises a retainer, wherein the end of the electric conductor is pressed by force and/or screwed by torque into the retainer.

Known methods for connecting an electric conductor to a PCB have the disadvantage that either a high insertion force or torque has to be applied or that an additional process step, such as a soldering or welding process, is required. In mass production, this can lead to a higher reject rate and increased production costs.

It is therefore the object of the present invention to eliminate or at least partially eliminate the disadvantages described above for a method for connecting an electric conductor to a PCB. In particular, it is the object of the present invention to create a method for connecting an electric conductor to a PCB and an electric device, which avoids high process forces or additional soldering or welding processes in a simple and inexpensive manner.

The above object is achieved by the claims. Accordingly, the problem is solved by a method for connecting an electric conductor to a PCB with the features of the independent claim 1 and by an electric device with the features of the subordinate claim 10. Further features and details of the invention emerge from the subclaims, the description and the drawings. Features and details that are described in connection with the method for connecting an electric conductor to a PCB according to the invention naturally also apply in connection with the electric device according to the invention and vice versa, so that with regard to the disclosure of the individual aspects of the invention, reference is or can always be made to each other.

According to a first aspect of the invention, the object is achieved by a method for connecting an electric conductor to a PCB. The method comprises:
- Providing an electric connector with a connecting side for connecting the electric connector to the PCB and a coupling side for coupling the electric connector with the electric conductor, wherein the coupling side comprises an SMA material,
- Widening the coupling side from a memorized initial shape to a widened coupling shape,
- Inserting the connecting side into a retainer of the PCB,
- Inserting the electric conductor into the electric connector at the coupling side, and
- Thermally activating the electric connector at the coupling side in a way that the coupling side is reshaping in the direction of the memorized initial shape and the electric conductor is clamped by the coupling side.

The electric connector comprises the connecting side for connecting the electric connector to the PCB and the coupling side for coupling the electric connector with the electric conductor. Preferably, the electric connector is manufactured as a monolithic part, especially with the connecting side and the coupling side made of the same material. The electric connector is configured for being interposed between the electric conductor and the PCB in a way that the electric connector is electrically and mechanically connected to the electric conductor and to the PCB. By means of the electric connector, the electric conductor can be electrically and mechanically connected to the PCB at least indirectly. In other words, the electric connector is configured for providing an adapter between the electric conductor and the PCB.

According to the invention, at least the coupling side of the electric connector comprises the SMA material. This can also mean that the coupling side consists of the SMA material. SMA material stands for a "*shape memory alloy*"*.* An SMA material is a material, which is electrically conductive and has a memorized initial shape. The SMA material can be deformed by force from the memorized initial shape into a transformed shape. By thermally activating the SMA material in the transformed shape, the SMA material can be brought back into the memorized initial shape or at least a shape close to the memorized initial shape or at least closer to the memorized initial shape than the transformed shape.

The coupling side of the electric connector is widened from the memorized initial shape to the widened coupling shape. In the memorized initial shape, an inner diameter of the coupling side is smaller than an outer diameter of the electric conductor or at least of the part of the electric conductor, which is inserted into the coupling side when executing the method according to the invention. In the widened coupling shape, the inner diameter of the coupling side is larger than the outer diameter of the electric conductor or at least of the part of the electric conductor, which is inserted into the coupling side when executing the method according to the invention. Without any thermal activation, the coupling side stays in the widened coupling shape.

Moreover, the connecting side of the electric connector is inserted into the retainer of the PCB. For this purpose, it is preferred that an end of the connecting side, which enters the retainer at first, has a rounded, inclined or chamfered shape. Thus, the alignment of the electric connector with the retainer is improved. Preferably, the connecting side and the retainer are configured in a way that a pushing force for this insertion is low, e.g., less than 10 N. The retainer can be configured as one or more electrically contacted holes, especially through holes, of the PCB. Alternatively, the retainer can be configured as a surface mounted device (SMD) of the PCB. In this case, the retainer can be, e.g., soldered or welded onto the PCB.

At the coupling side, the electric conductor is inserted into the electric connector. Since the coupling side is still in the widened coupling state and the inner diameter of the inner diameter of the coupling side in the widened coupling state is larger than the outer diameter of the electric conductor, this insertion process can be performed with a low insertion force, e.g., less than 10 N, as well. Preferably, the inner diameter of the connecting side that is adjacent to the coupling side is smaller than the outer diameter of the electric conductor. Thus, the insertion of the electric conductor into the electric connector is limited by form fit. For stability reasons, it is preferred that the insertion is performed until the electric conductor reaches this form fit limit of the electric connector.

When the electric conductor is inserted into the electric connector, the coupling side of the electric connector is thermally activated, e.g., by applying heat to the electric connector. As a result of this thermal activation, the SMA material of the coupling side is activated and changes the shape of the coupling side from the widened coupling shape towards the memorized initial shape. During this reshaping process, since the outer diameter of the electric conductor is larger than the inner diameter of the coupling side in the memorized initial shape, the coupling side gets in close contact with a circumference of the electric conductor and, thereby, establishes a circumferential pushing force onto the electric conductor. By these means, the electric conductor is clamped within the coupling side. Dependent on the outer diameter, the material and the density of the electric conductor, the reshaping process ends with the coupling side having the memorized initial shape or a shape between the memorized initial shape and the widened coupling shape.

A method for connecting an electric conductor to a PCB according to the invention has the advantage over conventional methods that the electric conductor is connected to the PCB in a simple and inexpensive way. Due to the usage of the SMA material of the electric connector and the widening process of the coupling side, the pushing forces and torques for inserting the electric conductor into the electric connector can be reduced significantly compared to conventional pushing or screwing coupling methods. Moreover, due to the SMA material and the reshaping of the coupling side by thermal activation, a reliable electrical and mechanical connection between the electric connector and the electric conductor is established. Thus, no additional soldering or welding processes are required. By these means, the production processes are improved.

According to a preferred further development of the invention, a method can provide that an electric connector is provided, which comprises the SMA material at the coupling side and the connecting side. Preferably, the whole electric connector comprises the SMA material or is made of the SMA material. This has the advantage that in a simple and inexpensive way, the production process and the production costs of the electric connector can be reduced.

It is preferred according to the invention that the connecting side is deformed from the memorized initial shape to a connecting shape, and wherein after inserting the connecting side into the retainer of the PCB, the connecting side is thermally activated in a way that the connecting side is reshaping in the direction of the memorized initial shape and the connecting side is press fitted into the retainer. Preferably, with the connecting shape, the connecting side has a smaller outer diameter than with the memorized initial shape. Thus, the inserting process can be performed with a reduced pushing force. After the thermal activation of the connecting side, the outer diameter is increased again and, by these means, a holding force or resistance for securing the connecting side within the retainer, is increased. Preferably, the thermal activation of the connecting side is performed by the thermal activation of the coupling side. This has the advantage that in a simple and inexpensive way, the assembly process is further improved, wherein a high reliability of the connection is maintained.

It is also preferred, that the inserting of the connecting side into the retainer of the PCB is performed by press fitting. For the press fitting process, the pushing forces are preferably larger than 10 N. Further preferred, the tip end of the connecting side is inclined, preferably with a triangular or trapezoid cross-section. Further preferred, a part of the inclined tip end has a maximum extension followed by smaller outer dimensions, e.g., by a step, inclination or the like. This has the advantage that in a simple and inexpensive way, a secure electrical and mechanical connection between the PCB and the electric connector is ensured.

In a particularly preferred embodiment of a method according to the invention, the connecting side is inserted into a retainer of the PCB, which is configured as a through hole of the PCB. The retainer can also be configured as a plurality of through holes, wherein the connecting side preferably has a plurality of connectors, which are inserted into one of the through holes each. Preferably, the through hole has a circular cross-section. Alternatively, the through hole can have a rectangular, e.g., square, cross-section or the like. Further preferred, the through hole has smaller dimensions, e.g., a smaller diameter than the connecting side that is inserted into the through hole. This has the advantage that in a simple and inexpensive way, a secure electrical and mechanical connection between the PCB and the electric connector is ensured.

Preferably, the electric connector is provided by a stamping process and bent about a longitudinal axis by a machining process into the memorized initial shape. The electric connector can be manufactured from a metal stripe, sheet or the like. In a punching step, the electric connector can be cut off the metal stripe, wherein, preferably, all outlines of the electric connector are manufactured in this punching step. As a result, an outspread electric connector is provided. In the bending process, the outspread electric connector is bent about its longitudinal axis in a way that the longitudinal edges are facing each other. There may be a longitudinal slit between the adjacent longitudinal edges. It is preferred that, in this state, the electric connector is in the memorized initial shape. Furthermore, the electric connector is bent in a way that, at the coupling side, an insertion clearance for inserting the free end of the electric conductor is provided. In this state, however, the inner diameter of this clearance is smaller than the outer diameter of the free end of the electric conductor. Therefore, the widening process is performed. This has the advantage that in a simple and inexpensive way, a reliable electric connector is provided.

According to a preferred embodiment of the invention, an electric connector with the connecting side comprising a flexible connecting portion is provided, wherein the connecting side is inserted into the retainer such that the flexible connecting portion is elastically compressed. Within the scope of the invention, a flexible connection side is considered a connection side, which can be elastically deformed during the insertion process. By these means, a radial pressure force between the connecting portion and the retainer is established. With this pressure force, the electric connector can be secured inside the retainer from falling off. This has the advantage that in a simple and inexpensive way, a secure attachment of the electric connector at the retainer is provided.

Particularly preferred, the connecting side is further inserted into the retainer such that the elastically compressed flexible connecting portion is elastically relaxed. In other words, during the insertion process, the connecting side is compressed and relaxed during further insertion. The elastic relaxing has the effect that outer dimensions of the connecting side increase, thus forming an undercut with the retainer. This has the advantage that in a simple and inexpensive way, the secure attachment of the electric connector at the retainer is further improved.

It is preferred according to the invention that an electric conductor is provided, which is configured as a cylindrical conductive pin. Preferably, the cylindrical conductive pin is massive. A massive conductive pin has several advantages over hollow pins, such as a better shape stability when exposed to outer pressure and a better electric conductivity. Alternatively, the cylindrical conductive pin is hollow, wherein, in this case, it is preferred that the cylindrical conductive pin comprises a stiffening structure for preventing the cylindrical conductive pin from being deformed by the coupling side after the thermal activation of the SMA material of the coupling side. This has the advantage that in a simple and inexpensive way, a reliable mechanical and electrical connection between the electric connector and the electric conductor is established.

According to a second aspect of the invention, the object is achieved by an electric device, e.g., for a vehicle, a plane, a ship, a building or the like. The electric device comprises a PCB, an electric conductor and an electric connector. The electric conductor is electrically and mechanically connected to the PCB by the electric connector. According to the invention, the connection between the electric conductor, the electric connector and the PCB is established by a method according to the invention. Preferably, the electric device comprises a housing for protecting the PCB and other components of the electric device from environmental influences.

The electric device according to the invention has all the advantages that have already been described for a method for connecting an electric conductor to a PCB according to the first aspect of the invention. Accordingly, the electric device according to the invention has the advantage over conventional electric devices, that in a simple and inexpensive way, the electric conductor is connected to the PCB. Due to the usage of the SMA material of the electric connector and the widening process of the coupling side, the pushing forces and torques for inserting the electric conductor into the electric connector can be reduced significantly compared to conventional pushing or screwed coupling methods. Moreover, due to the SMA material and the reshaping of the coupling side by thermal activation, a reliable electrical and mechanical connection between the electric connector and the electric conductor is established. Thus, no additional soldering or welding processes are required. By these means, the production processes of the electric device are improved.

Further advantages, features and details of the invention unfold from the following description, in which by reference to drawings, working examples of the present invention are described in detail. Thereby, the features from the claims as well as the features mentioned in the description can be essential for the invention as taken alone or in an arbitrary combination. In the drawings:
- Fig. 1: shows an electric connector in a prefinished state in a schematic side view,
- Fig. 2: shows the electric connector of Fig. 1 in a finished state in a schematic perspective view at a first moment when executing a preferred embodiment of the method according to the invention,
- Fig. 3: shows in a schematic perspective view the electric connector of Fig. 2 at a second moment when executing the preferred embodiment of the method according to the invention,
- Fig. 4: shows in a schematic perspective view the electric connector of Fig. 3 at a third moment when executing the preferred embodiment of the method according to the invention,
- Fig. 5: shows in a schematic perspective view an electric conductor at a fourth moment when executing the preferred embodiment of the method according to the invention,
- Fig. 6: shows in a schematic side view the electric connector of Fig. 4 and the electric conductor at a fifth moment when executing the preferred embodiment of the method according to the invention,
- Fig. 7: shows in a schematic perspective view the electric connector and the electric conductor of Fig. 6 at a sixth moment when executing the preferred embodiment of the method according to the invention.

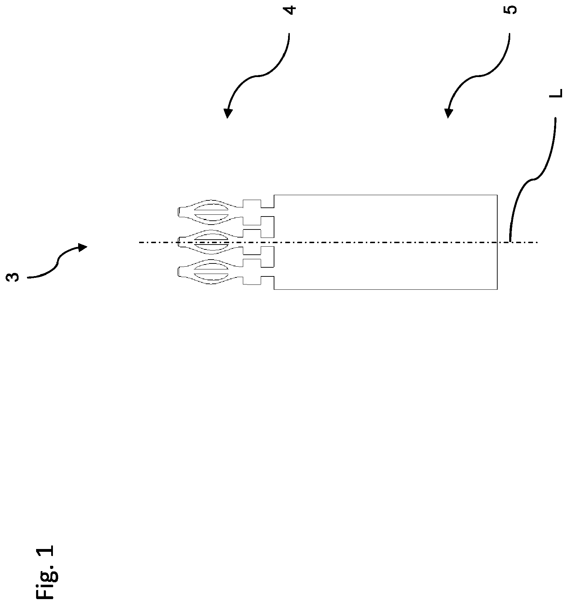

Elements with the same function and effectiveness are denoted each in figures 1 to 7 with the same reference numbers.

In Fig. 1, an electric connector 3 is shown in a prefinished state in a schematic side view. In the prefinished state, the electric connector 3 is punched off a metal stripe of an SMD metal. The electric connector 3 is in a flat state, extending along a longitudinal axis L. Furthermore, at a first longitudinal end, the electric connector 3 comprises a connecting side 4 and at a second longitudinal end, the electric connector 3 comprises a coupling side 5.

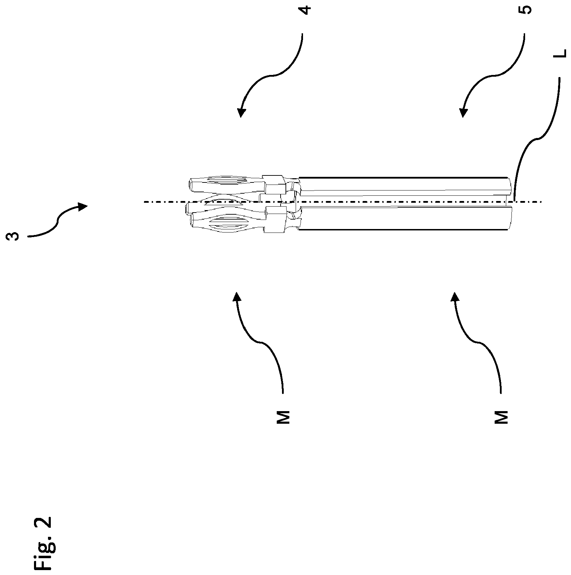

In Fig. 2, the electric connector 3 of Fig. 1 is shown in a finished state in a schematic perspective view at a first moment when executing a preferred embodiment of the method according to the invention. In the finished state, the electric connector 3 is bent about the longitudinal axis L. By these means, an inner clearance is formed within the electric connector 3. In the finished state, the electric connector 3 is provided at the first moment when executing a preferred embodiment of the method. The connecting side 4 and the coupling side 5 are in the memorized initial state M.

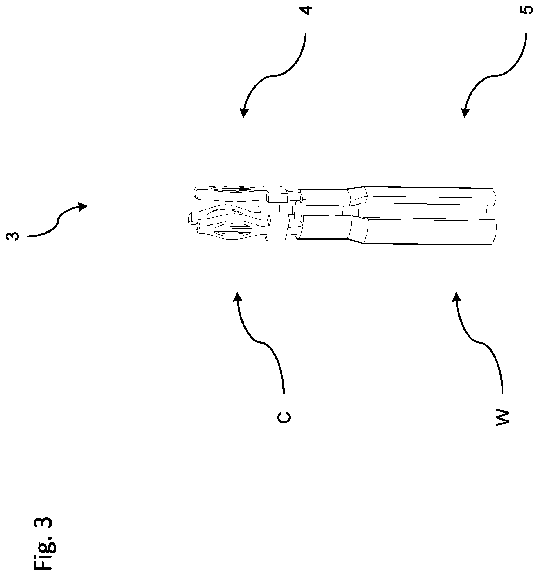

Fig. 3 shows the electric connector 3 of Fig. 2 in a schematic perspective view at a second moment when executing the preferred embodiment of the method according to the invention. From the first moment to the second moment, the electric connector 3 has been machined in a way that the connecting side 4 is compressed into a connecting shape C with a reduced outer diameter and the coupling side 5 is widened into a widened coupling shape W with an increased inner diameter. In this example, the degree of compression of the connecting side 4 is less than the degree of widening of the coupling side 5.

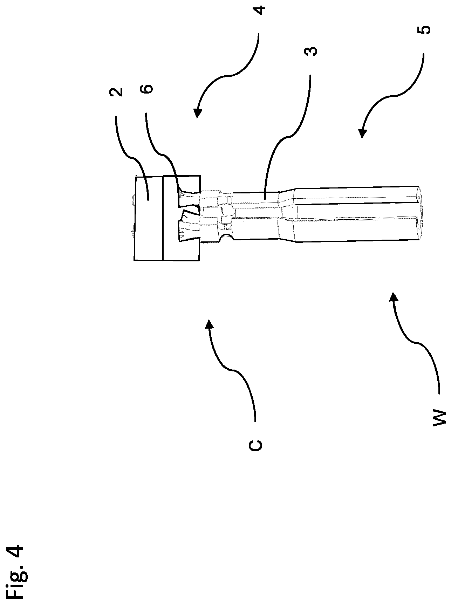

In Fig. 4, the electric connector 3 of Fig. 3 is shown in a schematic perspective view at a third moment when executing the preferred embodiment of the method according to the invention. From the second moment to the third moment, the connecting side 4 has been inserted into a retainer 6 of a PCB 2. Due to the dimensions of the connecting side 4 with the connecting shape C and the retainer 6, this insertion process is performed with low pressure force, e.g., less than 10 N.

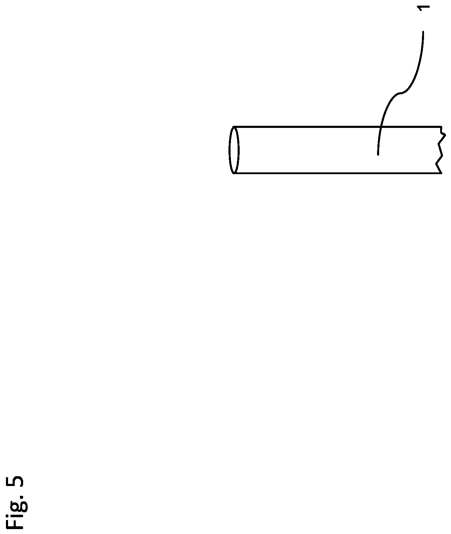

Fig. 5 shows in a schematic perspective view an electric conductor 1 at a fourth moment when executing the preferred embodiment of the method according to the invention. At the fourth moment, the electric conductor 1 is provided for inserting into the coupling side 5 of the electric connector 3. The electric conductor 1 is configured as a cylindrical conductive pin.

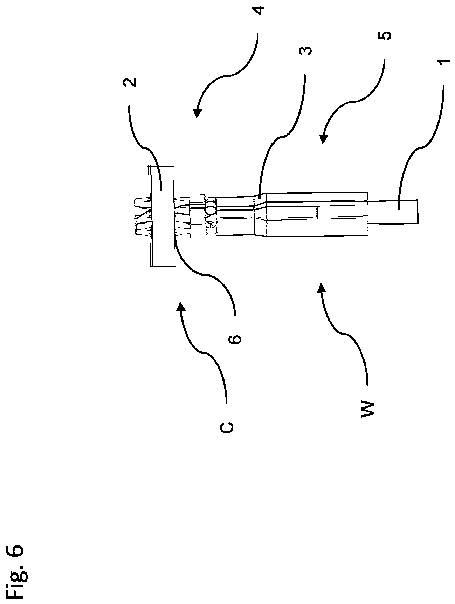

In Fig. 6, the electric connector 3 of Fig. 4 and the electric conductor 1 are shown in a schematic side view at a fifth moment when executing the preferred embodiment of the method according to the invention. At the fifth moment, the electric conductor 1 is inserted into the coupling side 5 of the electric connector 3. The connecting side 4 is still inserted into the retainer 6 of the PCB 2. Furthermore, the connecting side 4 is still in the connecting shape C and the coupling side 5 is still in the widened coupling shape W.

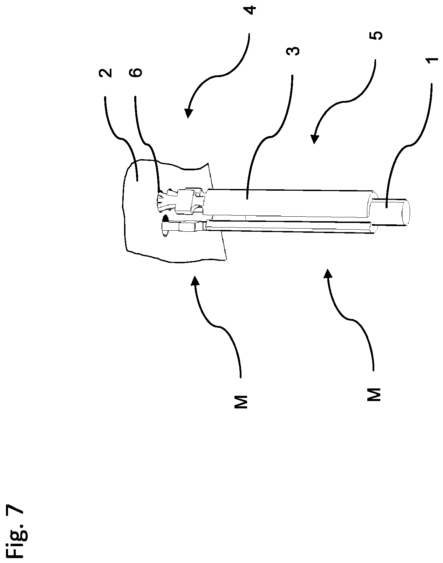

Fig. 7 shows in a schematic perspective view the electric connector 3 and the electric conductor 1 of Fig. 6 at a sixth moment when executing the preferred embodiment of the method according to the invention. From the fifth moment to the sixth moment, the electric connector 3 has been thermally activated, e.g., by heat, in a way that the connecting side 4 reshaped from the connecting shape C to the memorized initial shape M, thus improving the fixation of the electric connector 3 to the retainer 6 of the PCB 2. Moreover, the thermal activation has been performed such that the coupling side 5 reshaped from the widened coupling shape W to the memorized initial shape M, thus improving the fixation of the electric connector 3 to the electric conductor 1.

### List of reference signs

- 1: electric conductor
- 2: PCB
- 3: electric connector
- 4: connecting side
- 5: coupling side
- 6: retainer
- 7: electric device

- C: connecting shape
- L: longitudinal axis
- M: memorized initial shape
- W: widened coupling shape

## Claims

1. Method for connecting an electric conductor (1) to a PCB (2), comprising:
- Providing an electric connector (3) with a connecting side (4) for connecting the electric connector (3) to the PCB (2) and a coupling side (5) for coupling the electric connector (3) with the electric conductor (1), wherein the coupling side (5) comprises an SMA material,
- Widening the coupling side (5) from a memorized initial shape (M) to a widened coupling shape (W),
- Inserting the connecting side (4) into a retainer (6) of the PCB (2),
- Inserting the electric conductor (1) into the electric connector (3) at the coupling side (5), and
- Thermally activating the electric connector (3) at the coupling side (5) in a way that the coupling side (5) is reshaping in the direction of the memorized initial shape (M) and the electric conductor (1) is clamped by the coupling side (5).

2. Method according to claim 1, **characterized in that** an electric connector (3) is provided which comprises the SMA material at the coupling side (5) and the connecting side (4).

3. Method according to claim 2, **characterized in that** the connecting side (4) is deformed from the memorized initial shape (M) to a connecting shape (C), and wherein after Inserting the connecting side (4) into the retainer (6) of the PCB (2), the connecting side (4) is thermally activated in a way that the connecting side (4) is reshaping in the direction of the memorized initial shape (M) and the connecting side (4) is press fitted into the retainer (6).

4. Method according to any of the previous claims, **characterized in that** the inserting of the connecting side (4) into the retainer (6) of the PCB (2) is performed by press fitting.

5. Method according to any of the previous claims, **characterized in that** the connecting side (4) is inserted into a retainer (6) of the PCB (2), which is configured as a through hole of the PCB (2).

6. Method according to any of the previous claims, **characterized in that** the electric connector (3) is provided by a stamping process and bent about a longitudinal axis (L) by a machining process into the memorized initial shape (M).

7. Method according to any of the previous claims, **characterized in that** an electric connector (3) with the connecting side (4) comprising a flexible connecting portion is provided, wherein the connecting side (4) is inserted into the retainer (6) such that the flexible connecting portion is elastically compressed.

8. Method according to claim 7, **characterized in that** the connecting side (4) is further inserted into the retainer (6) such that the elastically compressed flexible connecting portion is elastically relaxed.

9. Method according to any of the previous claims, **characterized in that** an electric conductor (1) is provided, which is configured as a cylindrical conductive pin.

10. Electric device (7), comprising a PCB (2), an electric conductor (1) and an electric connector (3), wherein the electric conductor (1) is electrically and mechanically connected to the PCB (2) by the electric connector (3), **characterized in that** the connection between the electric conductor (1), the electric connector (3) and the PCB (2) is established by a method according to any of the previous claims.
